(19) Europäisches Patentamt
European Patent Office
Office européen des brevets

(11) EP 2 638 547 B1

(12) # EUROPEAN PATENT SPECIFICATION

(45) Date of publication and mention of the grant of the patent:
**08.07.2015 Bulletin 2015/28**

(21) Application number: **11787605.2**

(22) Date of filing: **08.11.2011**

(51) Int Cl.:
*H01B 1/12* (2006.01)
*C08G 61/12* (2006.01)
*H01L 51/00* (2006.01)
*C08K 5/3472* (2006.01)
*C08K 5/3492* (2006.01)
*C08L 65/00* (2006.01)
*H01B 19/04* (2006.01)
*H01G 11/48* (2013.01)
*H01G 11/56* (2013.01)

(86) International application number:
**PCT/EP2011/005600**

(87) International publication number:
**WO 2012/062446 (18.05.2012 Gazette 2012/20)**

(54) **METHOD FOR PRODUCING LAYER STRUCTURES BY TREATMENT WITH ORGANIC ETCHANTS AND LAYER STRUCTURES OBTAINABLE THEREFROM**

VERFAHREN ZUR HERSTELLUNG VON SCHICHTSTRUKTUREN DURCH BEHANDLUNG MIT ORGANISCHEN ÄTZMITTELN AUF DIESE WEISE HERSTELLBARE SCHICHTSTRUKTUREN

PROCÉDÉ DE PRODUCTION DE STRUCTURES À COUCHES PAR TRAITEMENT AU MOYEN D'AGENTS DE GRAVURE ORGANIQUES ET STRUCTURES À COUCHES AINSI OBTENUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.11.2010 US 411023 P**
**08.11.2010 DE 102010050507**

(43) Date of publication of application:
**18.09.2013 Bulletin 2013/38**

(73) Proprietor: **Heraeus Deutschland GmbH & Co. KG**
**63450 Hanau (DE)**

(72) Inventors:
- **GUNTERMANN, Udo**
**47800 Krefeld (DE)**
- **GAISER, Detlef**
**51061 Köln (DE)**

(74) Representative: **Herzog, Fiesser & Partner Patentanwälte PartG mbB**
**Immermannstrasse 40**
**40210 Düsseldorf (DE)**

(56) References cited:
**EP-A1- 1 054 414**
**EP-A1- 2 071 591**
**EP-A2- 2 704 205**
**WO-A1-01/39287**
**WO-A1-2009/122923**
**WO-A1-2010/139051**
**JP-A- 2004 047 446**
**US-A1- 2008 187 764**
**US-A1- 2009 322 218**

- **T.P. NGUYEN ET AL: "An investigation into the effect of chemical and thermal treatments on the structural changes of poly(3,4-ethylenedioxythiophene)/polystyre nesulfonate and consequences on its use on indium tin oxide substrates", APPLIED SURFACE SCIENCE, vol. 221, no. 1-4, 1 January 2004 (2004-01-01), pages 330-339, XP55019611, ISSN: 0169-4332, DOI: 10.1016/S0169-4332(03)00952-8**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

The present invention relates to a method for producing a layer structure.

Conductive polymers are increasingly gaining in economic importance, since polymers offer advantages over metals with regard to processability, weight and the selective adjustment of properties by means of chemical modification. Examples of known $\pi$-conjugated polymers are polypyrroles, polythiophenes, polyanilines, polyacetylenes, polyphenylenes and poly(p-phenylene vinylenes). Layers of conductive polymers are technically versatile in use, for example as polymeric counter-electrodes in capacitors or for through-hole plating in printed circuit boards. Conductive polymers are produced by chemical or electrochemical oxidation from monomeric precursors, such as for example optionally substituted thiophenes, pyrroles and anilines and optionally oligomeric derivatives thereof. Chemical oxidative polymerisation in particular is widespread, since it is technically simple to carry out in a liquid medium or on diverse substrates.

A particularly important polythiophene used technically is poly(ethylene-3,4-dioxythiophene) (PEDOT or PEDT) as described for example in EP 0 339 340 A2, which is produced by chemical polymerisation of ethylene-3,4-dioxythiophene (EDOT or EDT) and which in its oxidised form exhibits very high conductivity values. A survey of numerous poly(alkylene-3,4-dioxythiophene) derivatives, in particular poly(ethylene-3,4-dioxythiophene) derivatives, their monomer units, syntheses and applications is provided by L. Groenendaal, F. Jonas, D. Freitag, H. Pielartzik & J. R. Reynolds, Adv. Mater. 12, (2000) p. 481-494.

Dispersions of PEDOT with polyanions, such as for example polystyrene sulphonic acid (PSS), as disclosed for example in EP 0 440 957 A2, have acquired particular importance in industry. These dispersions can be used to produce transparent, conductive films which have found numerous applications, for example as an antistatic coating or as a hole-injection layer in organic light-emitting diodes (OLEDs), as shown in EP 1 227 529 A2.

The polymerisation of EDOT takes place in an aqueous solution of the polyanion to form a polyelectrolyte complex. Cationic polythiophenes, which for the purposes of charge compensation comprise polymeric anions as counterions, are often also referred to by experts as polythiophene/polyanion complexes. By virtue of the polyelectrolyte properties of PEDOT as a polycation and PSS as a polyanion this complex is not a true solution but rather a dispersion. The extent to which polymers or portions of polymers are dissolved or dispersed is dependent on the mass ratio of the polycation and the polyanion, on the charge density of the polymers, on the salt concentration of the environment and on the nature of the surrounding medium (V. Kabanov, Russian Chemical Reviews 74, 2005, 3-20). The transitions here can be fluid. For that reason no distinction is made hereafter between the terms "dispersed" and "dissolved". Likewise no distinction is made between "dispersion" and "solution" or between "dispersant" and "solvent". Rather these terms are used synonymously hereafter.

There is a great need to be able to pattern electrically conductive layers based on conductive polymers, in particular based on complexes consisting of polythiophenes and polyanions, in a similar way to ITO layers (= indium tin oxide layers), "*patterning*" referring here and hereafter to any measure which in a sub-area or in multiple sub-areas of the layer of electrically conductive polymers leads to an at least partial reduction and preferably to a complete elimination of the conductivity.

One possibility for producing patterned layers based on conductive polymers is to apply these polymers to surfaces in a patterned way by means of certain printing methods, as described for instance in EP-A-1 054 414. The disadvantage of this approach, however, is that the electrically conductive polymers have to be converted into a paste, which in view of the tendency of conductive polymers to aggregate is sometimes problematic. Moreover, the application of electrically conductive polymers by means of printing pastes has the disadvantage that the outer area of the liquid droplet is thicker than the inner area and that consequently when the pastes are dried the coating is thicker in the outer area than in the inner area. The resulting unevenness in the film thickness often has a detrimental effect on the electrical properties of the electrically conductive layer. A further disadvantage of patterning by means of printing pastes is that they are only applied in areas in which electrical conductivity of a substrate surface is desired. This results in considerable differences in colour on the substrate surface between areas with and without an application of printing paste, such differences being however generally undesirable.

In addition to the use of printing pastes, another possibility for producing patterned coatings from conductive polymers is first to produce a uniform, unpatterned coating of electrically conductive polymers and to pattern it only subsequently, by photobleaching methods or by the use of etching solutions, for example. Thus WO-A-2009/122923 and WO-A-2008/041461 for example describe methods in which layers of electrically conductive polymers are patterned by means of cerium-ammonium nitrate solutions having an etching action. The disadvantage of this approach, however, is that inter alia such etching solutions remove the coating of the electrically conductive polymer to a great extent, and these changes to the surface finish thus have an adverse effect on the external appearance of the coating. The colour of the coating in particular is critically compromised by patterning with cerium-containing etching solutions.

WO 01/39287 A1 discloses the use of a mixture comprising reactive oxygen species and reactive fluorine and/or chlorine species in the production of an organic light-emissive device, comprising an organic light-emissive region provided between two electrodes such that charge carriers can move between the electrodes and the organic light-emissive region, for etching the organic light-emissive region.

US 2008/187764 A1 discloses a nano- or micro-scale organic-inorganic composite device comprising a first electrode, a second electrode, and a photoactive layer, the photoactive layer comprised of a conductive polymer, the conductive polymer comprised of a fullerene and a polymer, the photoactive layer interposed between the first electrode and the second electrode.

IP 2004-047446 A1 discloses a method for manufacturing an active matrix type light emitting device and the configuration of such an active matrix type light emitting device having high reliability. In the method, a contact hole extending to a source region or a drain region is formed, and then an interlayer insulation film made of a photosensitive organic insulating material is formed on an interlayer insulation film. The interlayer insulation film has a curved surface on its upper end portion. Subsequently, an interlayer insulation film provided as a silicon nitride film having a film thickness of 20 to 50 nm is formed.

EP 2 704 205 A2 discloses a method comprising providing a monocrystalline semiconductor substrate, providing a composition comprising one or more compounds chosen from hydantoin and hydantoin derivatives, one or more alkoxylated glycols and one or more alkaline compounds and contacting the monocrystalline semiconductor substrate with the composition to anisotropically texture the monocrystalline semiconductor substrate.

The object of the present invention was to overcome the disadvantages arising from the prior art in connection with the patterning of layers of electrically conductive polymers, in particular of layers comprising polythiophenes.

In particular, the object of the present invention was to provide a method for patterning a layer of electrically conductive polymers, in particular a layer comprising polythiophene, with which in certain areas of this layer the conductivity can be reduced, preferably completely eliminated, without the colour of the layer being influenced in any appreciable way by this patterning.

The object of the present invention was also to provide a method for patterning a layer of electrically conductive polymers, in particular a layer comprising polythiophenes, with which in certain areas of this layer the conductivity can be reduced, preferably completely eliminated, without the thickness of the coating and hence the external appearance of the layer being influenced in any appreciable way by this patterning

A contribution to achieving the objects set out in the introduction is made by a method as defined in claim 1.

Completely surprisingly, but no less advantageously for that, it was found that through the use of the organic compounds as defined in claim 1 the surface of coatings of electrically conductive polymers can be patterned to such an extent that in the areas treated with these organic compounds the conductivity can be almost completely eliminated in a very short time without the coating itself being appreciably affected in these areas. The external appearance, in particular however the colour and also the transmission of the layer structure treated with these organic compounds, is scarcely compromised by the treatment.

In process step i) of the method according to the invention a layer structure is first provided comprising a substrate and an electrically conductive layer on top of the substrate which comprises an electrically conductive polymer. The formulation *"an electrically conductive layer on the substrate"* encompasses both layer structures in which the electrically conductive layer is applied directly onto the substrate and also layer structures in which one or more interlayers are provided between the substrate and the electrically conductive layer.

Plastic films in particular are preferred as the substrate in this connection, most particularly preferably transparent plastic films, which conventionally have a thickness in a range from 5 to 5000 μm, particularly preferably in a range from 10 to 2500 μm and most preferably in ma range from 25 to 1000 μm. Such plastic films can be based for example on polymers such as poly-carbonates, polyesters such as for example PET and PEN (polyethylene terephtalate and polyethylene naphthalene dicarboxylate), copolycarbonates, polysulphones, polyether sulphones (PES), polyimides, polyamides, polyethylene, polypropylene or cyclic polyolefins or cyclic olefin copolymers (COC), polyvinyl chloride, polystyrene, hydrogenated styrene polymers or hydrogenated styrene copolymers. In addition to plastic materials, substrates based in particular on metals or metal oxides are also suitable as substrates, such as for example ITO layers (indium tin oxide layers) or the like. Glass is also preferred as a substrate.

On this substrate is a layer comprising an electrically conductive polymer, wherein all electrically conductive polymers known to the person skilled in the art are suitable as the electrically conductive polymer. Polythiophenes, polypyrrole or polyanilines are mentioned in particular here as examples of suitable electrically conductive polymers.

Electrically conductive polymers that are particularly preferred according to the invention are polythiophenes, wherein all polymers with repeating units of the general formula (V)

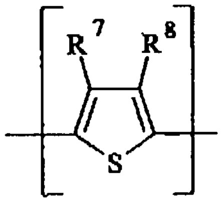

(V)

in which

$R^7$ and $R^8$ independently of each other each denote H, an optionally substituted $C_1$-$C_{18}$ alkyl radical or an optionally substituted $C_1$-$C_{18}$ alkoxy radical, $R_1$ and $R_2$ together denote an optionally substituted $C_1$-$C_8$ alkylene radical, wherein one or more C atoms can be replaced by one or more identical or different heteroatoms selected from O or S, preferably a $C_1$-$C_8$ dioxyalkylene radical, an optionally substituted $C_1$-$C_8$ oxythiaalkylene radical or an optionally substituted $C_1$-$C_8$ dithiaalkylene radical, or an optionally substituted $C_1$-$C_8$ alkylidene radical, wherein optionally at least one C atom is replaced by a heteroatom selected from O or S,

can be used in principle as polythiophenes.

In a particularly preferred embodiment of the method according to the invention polythiophenes are preferred which comprise repeating units of the general formula (V-a) and/or the general formula (V-b):

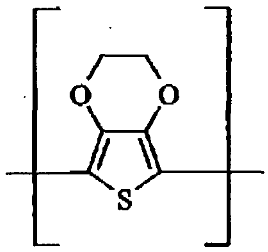

(V-a)

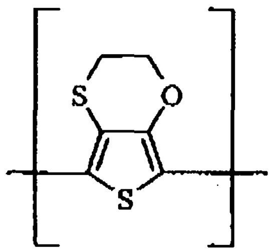

(V-b)

In the context of the invention the prefix "poly" is understood to mean that more than one identical or different repeating unit is comprised in the polythiophene. The polythiophenes comprise in total n repeating units of the general formula (V), wherein n can be a whole number from 2 to 2000, preferably 2 to 100. The repeating units of the general formula (V) within a polythiophene can in each case be identical or different. Polythiophenes comprising in each case identical repeating units of the general formula (V) are preferred.

The polythiophenes preferably each bear H at the end groups.

In particularly preferred embodiments the polythiophene is poly(3,4-ethylenedioxythiophene), poly(3,4-ethyleneoxythiathiophene) or poly(thieno[3,4-b]thiophene, whereby poly(3,4-ethylenedioxythiophene) is most preferred.

The optionally substituted polythiophenes are cationic, wherein "cationic" relates only to the charges located on the polythiophene main chain. Depending on the substituent at the radicals $R^7$ and $R^8$, the polythiophenes can bear positive and negative charges in the structural unit, the positive charges being located on the polythiophene main chain and the negative charges optionally at the radicals R substituted with sulphonate or carboxylate groups.

The positive charges of the polythiophene main chain can be partially or completely saturated by the optionally present anionic groups at the radicals R. Considered as a whole, the polythiophenes can be cationic, neutral or even anionic in these cases. Nevertheless, in the context of the invention they are all considered as cationic polythiophenes, since the positive charges on the polythiophene main chain are decisive. The positive charges are not represented in the formulae because they are mesomerically delocalised. However, the number of positive charges is at least 1 and at most n, where n is the total number of all repeating units (identical or different) within the polythiophene.

It is however particularly preferable according to the invention for the positive charges on the polythiophene main chain to be compensated for by polyanions, a polyanion being understood to be preferably a polymeric anion comprising at least 2, particularly preferably at least 3, still more preferably at least 4 and most preferably at least 10 identical, anionic monomer repeating units, which do not however necessarily have to be linked directly to one another.

In this case the electrically conductive composition therefore comprises a polyanion in addition to the electrically conductive polymer, in particular in addition to the polythiophene.

Polyanions can for example be anions of polymeric carboxylic acids, such as polyacrylic acids, polymethacrylic acid or polymaleic acids, or polymeric sulphonic acids, such as polystyrene sulphonic acids and polyvinyl sulphonic acids. These polycarboxylic and polysulphonic acids can also be copolymers of vinyl carboxylic and vinyl sulphonic acids with other polymerisable monomers, such as acrylates and styrene. The dispersions provided in process step I) preferably comprise an anion of a polymeric carboxylic or sulphonic acid as the polyanion.

The anion of polystyrene sulphonic acid (PSS) is particularly preferred as the polyanion. The molecular weight ($M_w$) of the polyacids yielding the polyanions is preferably 1000 to 2,000,000, particularly preferably 2000 to 500,000. The molecular weight is determined by gel permeation chromatography using polystyrene sulphonic acids of defined molecular weights as the calibration standard. The polyacids or alkali salts thereof are available commercially, for example polystyrene sulphonic acids and polyacrylic acids, or can be produced by known methods (see for example Houben Weyl, Methoden der organischen Chemie, Vol. E 20 Makromolekulare Stoffe, Part 2, (1987), p. 1141 ff.).

It is particularly preferable in this connection for the electrically conductive layer to comprise a complex of the electrically conductive polymer, in particular the polythiophene described above, and one of the polyanions described above, particularly preferably a complex consisting of poly(3,4-ethylenedioxythiophene) and polystyrene sulphonic acid (so called PRDOT/PSS complexes). The weight ratio of polythiophene to polyanion in these complexes is preferably in a range from 1 : 0.3 to 1 : 100, preferably in a range from 1 : 1 to 1 : 40, particularly preferably in a range from 1 : 2 to 1 : 20 and extremely preferably in a range from 1 : 2 to 1 : 15.

In this connection it is furthermore preferable for the electrically conductive layer to comprise 1 to 100 wt.%, particularly preferably at least 5 wt.% and most preferably at least 10 wt.%, relative in each case to the total weight of the electrically conductive layer, of the aforementioned complexes comprising an electrically conductive polymer and a polyanion, particularly preferably the complexes of poly(3,4-ethylenedioxythiophene) and polystyrene sulphonic acid.

The complexes comprising electrically conductive polymer and polyanion described above are preferably obtainable by oxidative polymerisation of the monomers from which the electrically conductive polymer is formed, in the presence of the anion. In the case of complexes of poly(3,4-ethylenedioxythiophene) and polystyrene sulphonic acid the complexes are therefore obtainable by oxidative polymerisation of 3,4-ethylenedioxythiophene in the presence of the polystyrene sulphonic acid.

Methods for producing the monomeric precursors for the production of the polythiophenes comprising repeating units of the general formula (III) and derivatives thereof are known to the person skilled in the art and are described for example in L. Groenendaal, F. Jonas, D. Freitag, H. Pielartzik & J. R. Reynolds, Adv. Mater. 12 (2000) 481-494 and in the literature cited therein. Mixtures of different precursors can also be used.

Within the meaning of the invention derivatives of the aforementioned thiophenes are understood to be for example dimers or trimers of these thiophenes. Higher-molecular-weight derivatives, i.e. tetramers, pentamers, etc., of the monomeric precursors are also possible as derivatives. The derivatives can be made up of both identical and different monomer units and can be used in pure form and in mixtures with one another and/or with the aforementioned thiophenes. Oxidised or reduced forms of these thiophenes and thiophene derivatives are also encompassed within the meaning of the invention by the term "thiophenes" and "thiophene derivatives", provided that their polymerisation gives rise to the same conductive polymers as with the aforementioned thiophenes and thiophene derivatives.

Most particularly preferred thiophene monomers are optionally substituted 3,4-ethylenedioxythiophenes, the use of unsubstituted 3,4-ethylenedioxythiophene as the thiophene monomer being most particularly preferred.

In the method according to the invention the thiophene monomers are oxidatively polymerised in the presence of the polyanions, preferably in the presence of polystyrene sulphonic acid. The oxidising agents that are suitable for the oxidative polymerisation of pyrrole can be used as oxidising agents; these are described for example in J. Am. Chem. Soc. 85,454 (1963). For practical reasons, inexpensive and easy-to-handle oxidising agents are preferred, for example iron(III) salts such as $FeCl_3$, $Fe(ClO_4)_3$ and the iron(III) salts of organic acids and inorganic acids comprising organic radicals, also $H_2O_2$, $K_2Cr_2O_7$, alkali and ammonium persulphates, alkali perborates, potassium permanganate and copper salts, such as copper tetrafluoroborate. The use of persulphates and of iron(III) salts of organic acids and of inorganic acids comprising organic radicals has the big applicational advantage that they are not corrosive. The iron(III) salts of sulphuric acid hemiesters of $C_1$-$C_{20}$ alkanols, for example the Fe(III) salt of lauryl sulphate, are cited by way of example as iron(III) salts of inorganic acids comprising organic radicals. The following are cited by way of example as iron(III) salts of organic acids: the Fe(III) salts of $C_1$-$C_{20}$ alkyl sulphonic acids, such as methane- and dodecanesulphonic acid; of aliphatic $C_1$-$C_{20}$ carboxylic acids such as 2-ethylhexyl carboxylic acid; of aliphatic perfluorocarboxylic acids, such as trifluoroacetic acid and perfluorooctanoic acid; of aliphatic dicarboxylic acids such as oxalic acid and above all of aromatic sulphonic acids optionally substituted with $C_1$-$C_{20}$ alkyl groups, such as benzenesulphonic acid, p-toluenesulphonic acid and dodecylbenzenesulphonic acid.

The oxidative polymerisation of the thiophene monomers of formula (V) theoretically requires 2.25 equivalents of oxidising agent per mol of thiophene (see for example J. Polym. Sc. Part A Polymer Chemistry Vol. 26, p. 1287 (1988)).

In practical terms, however, the oxidising agent is used in a certain excess, for example an excess of 0.1 to 2 equivalents per mol of thiophene.

The oxidative polymerisation of the thiophene monomers in the presence of the polyanions can take place in water or in water-miscible organic solvents, such as for instance methanol, ethanol, 1-propanol or 2-propanol, the use of water as a solvent being particularly preferred. If 3,4-ethylenedioxythiophene is used as the thiophene monomer and polystyrene sulphonic acid as the polyanion, aqueous dispersions are obtained in this way which are known as PEDOT/PSS dispersions and which are available for instance under the trade name Clevios™ P from H.C. Starck Clevios GmbH. The concentration of thiophene monomers and polyanions in the individual solvent is preferably chosen such that after oxidative polymerisation of the thiophene monomers in the presence of the polyanions a dispersion is obtained which comprises the complexes comprising the polythiophene and the polyanion in a concentration in a range from 0.05 to 50 wt.%, preferably in a range from 0.1 to 10 wt.% and still more preferably in a range from 1 to 5 wt.%.

The dispersions obtained following polymerisation are conventionally also treated with anion and/or cation exchangers, in order for example to at least partially remove from the dispersions metal cations that are still present in the dispersions.

According to a preferred embodiment of the method according to the invention the layer structure provided in process step i) is obtainable by a method comprising the process steps:

ia) Provision of the substrate;

ib) Application of a composition Z2 comprising the electrically conductive polymer and a solvent on at least a part of the surface of the substrate;

ic) At least partial removal of the solvent to obtain an electrically conductive layer.

In process step ia) a substrate is first provided, the substrates already mentioned above as preferred substrates being preferred as substrates. The surface of the substrates can be pretreated prior to applying the electrically conductive layer, for example by treatment with a primer, by corona treatment, flame treatment, fluorination or plasma treatment, to improve the polarity of the surface and hence the wettability and chemical affinity.

The dispersion described above, which is obtained following oxidative polymerisation of the thiophene monomers in the presence of the polyanions, and which was preferably treated in advance with ion exchangers, can be used for example as the composition Z2 comprising the electrically conductive polymer and optionally a polyanion as well as a solvent, said composition being applied in process step ib) to at least a part of the surface of the substrate, whereby the use of a PEDOT/PSS dispersion is particularly preferred.

Before such a dispersion is applied to the substrate surface in process step ib) as a coating composition for the purpose of forming an electrically conductive layer, further additives which for example raise the conductivity can also be added to the dispersion, such as for example ether group-comprising compounds such as for example tetrahydrofuran, lactone group-comprising compounds such as butyrolactone, valerolactone, amide group- or lactam group-comprising compounds such as caprolactam, N-methyl caprolactam, N,N-dimethyl acetamide, N-methyl acetamide, N,N-dimethyl formamide (DMF), N-methyl formamide, N-methyl formanilide, N-methyl pyrrolidone (NMP), N-octyl pyrrolidone, pyrrolidone, sulphones and sulphoxides, such as for example sulpholane (tetramethylene sulphone), dimethyl sulphoxide (DMSO), sugar or sugar derivatives, such as for example sucrose, glucose, fructose, lactose, sugar alcohols such as for example sorbitol, mannitol, furan derivatives such as for example 2-furan carboxylic acid, 3-furan carboxylic acid, and/or di- or polyalcohols such as for example ethylene glycol, glycerol or di- or triethylene glycol. Tetrahydrofuran, N-methyl formamide, N-methyl pyrrolidone, ethylene glycol, dimethyl sulphoxide or sorbitol are particularly preferably used as conductivity-raising additives.

One or more binders, such as polyvinyl acetate, polycarbonate, polyvinyl butyral, polyacrylic acid esters, polyacrylic acid amides, polymethacrylic acid esters, polymethacrylic acid amides, polystyrene, polyacrylonitrile, polyvinyl chloride, polyvinyl pyrrolidones, polybutadiene, polyisoprene, polyethers, polyesters, polyurethanes, polyamides, polyimides, polysulphones, silicones, epoxy resins, styrene/acrylate copolymers, vinyl acetate/acrylate copolymers and ethylene/vinyl acetate copolymers, polyvinyl alcohols or celluloses, can also be added to the dispersion. The proportion of the polymeric binder, if used, is conventionally in a range from 0.1 to 90 wt.%, preferably 0.5 to 30 wt.% and most particularly preferably 0.5 to 10 wt.%, relative to the total weight of the coating composition.

Bases or acids, for example, can be added to the coating compositions to adjust the pH. Additives which do not adversely affect the film forming of the dispersions are preferred, such as for example the bases 2-(dimethylamino)ethanol, 2,2'-iminodiethanol or 2,2',2''-nitrilotriethanol.

According to a particularly preferred embodiment of the method according to the invention the composition Z2 can also comprise crosslinking agents which allow crosslinking of the composition Z2 following application on the substrate surface. The solubility of the coating in organic solvents can be lowered in this way. Melamine compounds, capped

isocyanates, functional silanes, for example tetraethoxysilane, alkoxysilane hydrolysates based for example on tetraethoxysilane, or epoxysilanes such as 3-glycidoxypropyl trialkoxysilane are cited as examples of suitable crosslinking agents. These crosslinking agents can be added to the composition in an amount in a range from 0.01 to 10 wt.%, particularly preferably in an amount in a range from 0.05 to 5 wt.% and most preferably in an amount in a range from 0.1 to 1 wt.%, relative in each case to the total weight of the composition Z2.

This composition Z2 can then be applied to the substrate in process step ib) by known methods, for example by spin coating, dipping, pouring, dropping on, injecting, spraying, knife application, spreading or printing, for example inkjet, screen, intaglio, offset or pad printing, in a wet film thickness of 0.5 μm to 250 μm, preferably in a wet film thickness of 2 μm to 50 μm.

In process step ic) the solvent is then at least partially removed to obtain an electrically conductive layer, said removal preferably being performed by simple evaporation.

The thickness of the electrically conductive layer is preferably 1 nm to 50 μm, particularly preferably in a range from 1 nm to 5 μm and most preferably in a range from 10 nm to 500 nm.

In process step ii) of the method according to the invention for the purpose of patterning at least a part of the surface of the electrically conductive layer is then brought into contact with a composition Z1 comprising an organic compound capable of releasing chlorine, bromine or iodine as defined in claim 1.

The formulation "which is capable of releasing chlorine, bromine or iodine" is preferably understood according to the present invention as meaning an on organic compound, which, after addition of a solvent, preferably after addition of water, releases chlorine in the form of $Cl_2$, HOCl, $OCl^-$ or a mixture of at least two of these chlorine compounds, or bromine in the form of $Br_2$, HOBr, OBr" or a mixture of at least two of these bromine compounds, or iodine in the form of $I_2$, HIO, $IO^-$ or a mixture of at least two of these iodine compounds.

The organic compound capable of releasing chlorine, bromine or iodine is an organic compound comprising at least one structural element (I)

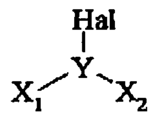

(I)

in which

- Hal is a halogen selected from the group consisting of chlorine, bromine or iodine, but preferably denotes chlorine or bromine,

- Y is selected from N, S and P, but preferably denotes N,
  and

- $X_1$ and $X_2$ can be the same or different and each denote a halogen, preferably chlorine or bromine, a carbon atom or a sulphur atom, wherein one or more further atoms can optionally be bonded to $X_1$ and $X_2$. The number of further atoms bonded to $X_1$ and $X_2$ is dependent on the covalence of $X_1$ and $X_2$.

According to a first particular embodiment of the method according to the invention the organic compound comprises at least two structural elements (I) in which Hal denotes a chlorine atom or a bromine atom and Y denotes nitrogen, wherein these at least two structural elements (I) can optionally also be different from one another. In this connection it is most particularly preferable according to a first variant of the method for the organic compound to comprise the structural element (II)

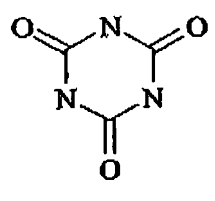

(II)

in which a chlorine atom or a bromine atom is bonded to at least two of the nitrogen atoms. Of these organic compounds, sodium dichlorodiisocyanurate, sodium dibromodiisocyanurate, tribromoisocyanuric acid and trichloroisocyanuric acid are particularly preferred.

According to a second method variant of this first particular embodiment of the method according to the invention it is preferable for the organic compound to comprise the structural element (III)

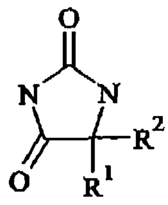

(III)

in which a chlorine atom or a bromine atom is bonded to the two nitrogen atoms and in which $R^1$ and $R^2$ can be the same or different and denote a hydrogen atom or a $C_1$-$C_4$ alkyl group, in particular a methyl group or an ethyl group.

Particularly preferred organic compounds in this connection are selected from the group consisting of bromo-3-chloro-5,5-dimethylhydantoin, 1-chloro-3-bromo-5,5-dimethylhydantoin, 1,3-dnchloro-5,5-dimethylhydantoin and 1,3-dibromo-5,5-dimethylhydantoin.

According to a second particular embodiment of the method according to the invention the organic compound comprises exactly one structural element (I). In this case too Y preferably denotes N.

According to a first method variant of this second particular embodiment of the method according to the invention the organic compound is N-chlorosuccinimide or N-bromosuccinimide.

According to a second method variant of this second particular embodiment of the method according to the invention the organic compound comprises the structural element (IV)

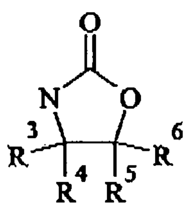

(IV)

in which a chlorine atom or a bromine atom is bonded to the nitrogen atom and in which $R^3$, $R^4$, $R^5$ and $R^6$ can be the same or different and denote a hydrogen atom or a $C_1$-$C_4$ alkyl group, which can optionally be substituted with bromine or chlorine. In this connection 3-bromo-5-chloromethyl-2-oxazolidinone, 3-chloro-5-chloromethyl-2-oxazolidinone, 3-bromo-5-bromomethyl-2-oxazolidinone and 3-chloro-5-bromomethyl-2-oxazolidinone can be cited as examples of suitable organic compounds.

Furthermore the organic compound according to the second particular embodiment of the method according to the invention can for example be halazone, an N,N-dichlorosulphonamide, an N-chloro-N-alkylsulphonamide or an N-bromo-N-alkylsulphonamide in which the alkyl group is a $C_1$-$C_4$ alkyl group, particularly preferably a methyl group or an ethyl group.

Also suitable as the organic compound according to a third particular embodiment of the method according to the invention are organic compounds selected from the group consisting of 5-chloro-2-methyl-4-isothiazolin-3-one, 4,5-dichloro-2-N-octyl-4-isothiazolin-3one, bromo-2-nitro-1,3-propanediol (BNPD), 2,2-dibromo-3-nitrilopropionamide, dibromonitro-ethyl propionate, dibromonitroethyl formate, sodium-*N*-chloro-(4-methylbenzene)sulphonamide or tetraglycine hydroperiodide.

The composition used in process step ii) is preferably an aqueous solution or dispersion in which the organic compound is dissolved or dispersed. In this connection it is particularly preferable for the aqueous solution or dispersion to have a pH determined at 25°C of at least 4, particularly preferably in a range from 4 to 12, particularly preferably in a range from 5 to 10 and most preferably in a range from 6 to 8.

The composition Z1, particularly preferably the aqueous solution or dispersion, preferably comprises the organic compound described above in a concentration in a range from 0.1 to 50 wt.%, particularly preferably in a range from 0.5

to 35 wt.% and most preferably in a range from 1 to 20 wt.%, relative in each case to the total weight of the composition Z1.

According to a further particular embodiment of the inventive process for producing a layer structure, the composition Z1 used in process step ii), preferably the solution or dispersion used in this process step, comprises as further component cyanuric acid as stabiliser, in addition to the above described organic compound. It has surprisingly been found that the rate of release of chlorine, bromine or iodine can be regulated by the addition of cyanuric acid. In the case of a use of a solution or dispersion of the organic compound in process step ii), the amount of cyanuric acid in the solution or dispersion preferably lies in a range of from 1 to 500 mg/L, particularly preferably in a range of from 10 to 100 mg/L.

The bringing into contact of the electrically conductive layer with the composition Z1 in process step ii) preferably takes place by dipping the electrically conductive layer into the composition Z1 or by printing the electrically conductive layer with the composition Z1, wherein however all the methods already described above as preferred application methods in connection with applying the composition Z2 to the substrate surface are in principle also suitable. To ensure an adequate patterning, the electrically conductive layer remains in contact with the composition Z1, preferably the aqueous solution or dispersion, for approximately 1 second to 30 minutes, particularly preferably for approximately 30 seconds to 15 minutes and most preferably approximately 1 to 5 minutes, before it is withdrawn again or before the composition Z1 is removed again. The temperature of the composition Z1 during the bringing into contact with the electrically conductive layer is preferably in a range from 10 to 40°C, particularly preferably in a range from 20 to 30°C, whereby the use of a composition Z1 at room temperature (25°C) is most preferred.

Various methods are suitable for bringing only a part of the electrically conductive layer of the layer structure into contact with the composition Z1 for the purpose of patterning. In the simplest case a patterning can be achieved by dipping only a part of the layer structure into the composition Z1 and correspondingly also bringing only a part of the electrically conductive layer into contact with the composition Z1. It is however also conceivable for the composition Z1 to be applied by for example printing on only certain areas of the electrically conductive layer on the layer structure. The use of templates with which the layer structures can be covered and which have cut-outs through which the composition Z1 can come into contact with certain areas of the electrically conductive layer is also conceivable. It is moreover also possible to use photolithography to bring about a patterning.

The method according to the invention can comprise as a further process step:

iii) Washing the electrically conductive layer brought into contact with the composition Z1,

wherein washing preferably takes place by dipping the layer structure into a solvent, for example water, and this can be followed by a drying step.

According to a particular embodiment of the method according to the invention the bringing into contact of the electrically conductive layer with the composition Z1 takes place under conditions such that the colour difference $\Delta Et_{before,\ after}$ is at most 4.5, particularly preferably at most 3.0 and most preferably at most 1.5, the colour difference $\Delta E_{before,\ after}$ being calculated as follows:

$$\Delta E_{before,after} = \sqrt{(L^*_{before} - L^*_{after})^2 + (a^*_{before} - a^*_{after})^2 + (b^*_{before} - b^*_{after})^2}$$

$L^*_{before}$ $a^*_{before}$ and $b^‡_{before}$ are the L, a and b values respectively of the L*a*b* colour space of the electrically conductive layer before being brought into contact with the composition Z1 and $L^*_{after}$, $a^*_{after}$ and $b^*_{after}$ are the L, a and b values respectively of the L*a*b* colour space of the (formerly) electrically conductive layer after being brought into contact with the composition Z1. For the purpose of the above requirement the layer should still be referred to as the "*electrically conductive layer"* after being brought into contact with the composition Z1, even if the electrical conductivity is negligible as a result of being brought into contact with the composition Z1.

In the method according to the invention it is furthermore preferable for the bringing into contact of the electrically conductive layer with the composition Z1 to take place under conditions such that the thickness of the electrically conductive layer in the areas brought into contact with the composition Z1 is reduced by at most 50%, particularly preferably by at most 25% and most preferably by at most 10%.

The layer structure obtainable by the method according to the invention can be used to produce electronic components, in particular organic light-emitting diodes, organic solar cells or capacitors, to produce touch panels or touch screens or to produce an antistatic coating.

Preferred electronic components are in particular organic light-emitting diodes, organic solar cells or capacitors, the use in capacitors, in particular the use as a solid electrolyte in capacitors with aluminium oxide as the dielectric, being particularly preferred.

The invention is now described in more detail by reference to figures, test methods and nonlimiting examples.

Figure 1 shows a cross-section of the structure of a layer structure 1, for example an antistatic films, in general form. On a substrate 2 a coating is applied which encompasses areas 3 with a surface resistance R and areas 4 with a surface resistance around 10 times greater than R. Figure 2 shows the same layer structure 1 from above.

Figure 3 shows the result of treating a printed PEDOT/PSS antenna layout by means of the method according to the invention in comparison with the results obtained by means of the methods known from the prior art.

TEST METHODS

Determining the surface resistance

To determine the surface resistance, Ag electrodes of length 2.5 cm are vapour coated using a shadow mask in such a way that a resistance measurement is possible in both areas A and B. The surface resistance is determined using an electrometer (Keithley 614). The determination was carried out by means of a so called four-point probe measurement as described for instance in US 6,943,571 B1.

Determining the colour values L, a and b and the transmission

The measurement of the transmission spectra of coated PET films is carried out in accordance with ASTM 308-94a. A Lambda 900 two-channel spectrophotometer from Perkin Elmer is used to this end. The instrument is fitted with a 15-cm photometer sphere. The correct function of the spectrophotometer is ensured and documented by regularly checking the wavelength calibration and the linearity of the detector in accordance with the manufacturer's recommendations.

In the transmission measurement the film to be measured is fixed in front of the inlet port of the photometer sphere by means of a retainer, so that the measuring beam penetrates the film with no shadowing. The film is visually homogeneous in the area of the penetrating measuring beam. The film is oriented with the coated side facing the sphere. The transmission spectrum is recorded at wavelength increments of 5 nm in the wavelength range from 320 to 780 nm. There is no sample in the reference beam path, so the spectrum is recorded against air.

The WinCol Version 1.2 software supplied by the instrument manufacturer is used for the colour evaluation of the transmission spectrum. Here the CIE tristimulus values (standard colour values) X, Y and Z of the transmission spectrum in the wavelength range 380 to 780 nm are calculated in accordance with ASTM 308-94a and DIN 503. From the standard colour values the chromaticity coordinates x and y and the CIELAB coordinates L*, a* and b* are calculated in accordance with ASTM 308-94a and DIN 5033.

EXAMPLES

Example 1

Etching a PEDOT/PSS-coated PET film strip with a solution of a cleaning agent comprising sodium dichlorodiisocyanurate:
Strips measuring approximately 2 × 10 cm are cut from a PET film coated with a PEDOT/PSS formulation. In addition, a saturated solution of the "Dr. Weigert neodisher LaboClean A8" cleaning agent (pH =10.0) is produced in water. The lower half of the strips is dipped into the solution. The surface resistances of the dipped and the undipped half are measured after 1, 2 and 3 minutes:

| Untreated | 329 $\Omega/cm^2$ | 329 $\Omega/cm^2$ | 329 $\Omega/cm^2$ |
|---|---|---|---|
| 1 min | 2.13 $k\Omega/cm^2$ | | |
| 2 min | | 2.43 $k\Omega/cm^2$ | |
| 3 min | | | 6.16 $k\Omega/cm^2$ |

Example 2

Etching a PEDOT/PSS-coated PET film strip with a sodium dichlorodiisocyanurate solution of pH = 6:
Strips measuring approximately 2 x 10 cm are cut from a PET film coated with a PEDOT/PSS formulation. In addition, a 5% and a 10% solution of sodium dichlorodiisocyanurate in water are prepared. The lower half of the strips is dipped into the solutions. The surface resistances of the dipped and the undipped half are measured:

| | 10% solution | 5% solution | 5% solution |
|---|---|---|---|
| Untreated | 387 Ω/$cm^2$ | 387 Ω/$cm^2$ | 387 Ω/$cm^2$ |
| 1 min | OL* | 4.75 kΩ/$cm^2$ | |
| 2 min | | | OL* |
| * OL is the reading on the instrument if a surface resistance > 30 MΩ/$cm^2$ is measured. | | | |

Example 3

Etching a PEDOT/PSS-coated PET film strip with a sodium dichlorodiisocyanurate solution of pH =10: Strips measuring approximately 2 x 10 cm are cut from a PET film coated with a PEDOT/PSS formulation. In addition, a 5% and a 10% solution of sodium dichlorodiisocyanurate in water are prepared and are adjusted with sodium hydroxide to pH = 10. The lower half of the strips is dipped into the solutions. The surface resistances of the dipped and the undipped half are measured:

| | 10% solution | 5% solution | 5% solution | 5% solution |
|---|---|---|---|---|
| Untreated | 356 Ω/$cm^2$ | 356 Ω/$cm^2$ | 356 Ω/$cm^2$ | 356 Ω/$cm^2$ |
| 1 min | OL* | 2.49 MΩ/$cm^2$ | | |
| 2 min | | | 4.3 MΩ/$cm^2$ | |
| 3 min | | | | OL* |

Example 4

Measuring the colour value of etched PEDOT/PSS layers:
The colour coordinates in the L*a*b* coordinates system were determined on the etched, no longer conductive pieces:

| | 10% solution | | | 5% solution | | |
|---|---|---|---|---|---|---|
| | L* | a* | b* | L* | a* | b* |
| Untreated | 95.24 | -0.77 | -1.38 | 95.24 | -1.06 | -1.05 |
| Etched | 94.78 | -0.71 | -1.02 | 94.84 | -0.93 | -0.65 |
| Difference amount | 0.46 | 0.06 | 0.36 | 0.40 | 0.13 | 0.40 |

and the transmission (Y D65/10° value) was measured:

| | 10% solution | 5% solution |
|---|---|---|
| Untreated | 88.18 | 88.19 |
| Etched | 87.09 | 87.23 |
| Difference amount | 1.09 | 0.96 |

The differences in colour coordinates and transmission were scarcely perceptible.

Example 5

Etching a printed PEDOT/PSS antenna layout:

The lower half of an antenna layout printed with a PEDOT/PSS formulation (see layout a) in Fig. 3) is dipped into the solution from Example 1. The dipped half shows a slight, scarcely perceptible lightening in colour, while the conductivity is completely destroyed (see layouts c) in Fig. 3). If by contrast the antenna layout is dipped into a

cerium nitrate solution, the PEDOT/PSS layer is extensively decolourised (see layout b) in Fig. 3).

## Claims

1. A method for patterning a layer structure, comprising the process steps:

   i) Providing a layer structure comprising a substrate and an electrically conductive layer, applied on the substrate, which comprises an electrically conductive polymer;
   ii) For the purpose of patterning bringing at least a part of the surface of the electrically conductive layer into contact with a composition Z1 comprising an organic compound capable of releasing chlorine, bromine or iodine, the organic compound comprising at least one structural element (I)

   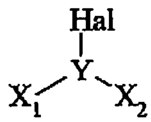

   (I)

   wherein

   - Hal is a halogen selected from the group consisting of chlorine, bromine or iodine,
   - Y is selected from N, S and P, and
   - $X_1$ and $X_2$ can be the same or different and each denote respectively a halogen, a carbon atom or a sulphur atom, and wherein one or more further atoms can optionally be bonded to $X_1$ and $X_2$.

2. The method according to claim 1, wherein the composition Z1 is an aqueous solution or dispersion with a pH of at least 4.

3. The method according to claim 1 or 2, wherein the electrically conductive layer comprises a polyanion in addition to the electrically conductive polymer.

4. The method according to claim 3, wherein the electrically conductive layer comprises complexes consisting of poly(3,4-ethylenedioxy-thiophene) and polystyrene sulphonic acid.

5. The method according to one of the preceding claims, wherein the electrically conductive layer is obtainable by a method comprising the process steps:

   ia) Provision of the substrate;
   ib) Application of a composition Z2 comprising the electrically conductive polymer and a solvent on at least a part of the surface of the substrate;
   ic) At least partial removal of the solvent to obtain an electrically conductive layer.

6. The method according to claim 5, wherein the composition Z2 is a dispersion comprising complexes of poly(3,4-ethylenedioxythiophene) and polystyrene sulphonic acid.

7. The method according to one of claims 1 to 6, wherein the organic compound comprises at least two structural elements (I) in which Hal denotes a chlorine atom or a bromine atom and Y denotes nitrogen, wherein the at least two structural elements (I) can optionally be different from one another.

8. The method according to claim 7, wherein the organic compound comprises the structural element (II)

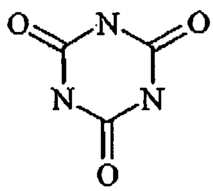

(II)

in which a chlorine atom or a bromine atom is bonded to at least two of the nitrogen atoms.

9. The method according to claim 8, wherein the organic compound is sodium dichlorodiisocyanurate, sodium dibromodiisocyanurate, tribromoisocyanuric acid or trichloroisocyanurïc acid.

10. The method according to one of claims 1 to 9, wherein the organic compound comprises the structural element (III)

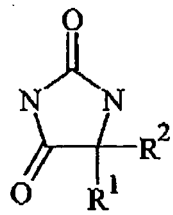

(III)

in which a chlorine atom or a bromine atom is bonded to the two nitrogen atoms and in which $R^1$ and $R^2$ can be the same or different and denote a hydrogen atom or a $C_1$-$C_4$ alkyl group.

11. The method according to claim 10, wherein the organic compound is 1-bromo-3-chloro-5,5-dimethylhydantoin, 1-chloro-3-bromo-5,5-dimethylhydantoin, 1,3-dichloro-5,5-dimethylhydantoin or 1,3-dibromo-5,5-dimethylhydantoin.

12. The method according to one of claims 1 to 6, wherein the organic compound comprises just one structural element (I), in which Y denotes N.

13. The method according to claim 12, wherein the organic compound is N-chlorosuccinimide or N-biomosuccinimide.

14. The method according to claim 12, wherein the organic compound comprises the structural element (IV)

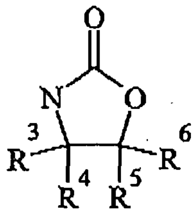

(IV)

in which a chlorine atom or a bromine atom is bonded to the nitrogen atom and in which $R^3$, $R^4$, $R^5$ and $R^6$ can be the same or different and denote a hydrogen atom or a $C_1$-$C_4$ alkyl group, which can optionally be substituted with bromine or chlorine.

15. The method according to claim 14, wherein the organic compound is selected from the group consisting of 3-bromo-5-chloromethyl-2-oxazolidinone, 3-chloro-5-chloromethyl-2-oxazolidinone, 3-bromo-5-bromomethyl-2-oxazolidinone and 3-chloro-5-bromomethyl-2-oxazolidinone.

**16.** The method according to claim 12, wherein the organic compound is halazone, an N,N-dichlorosulphonamide, an N-chloro-N-alkyl sulphonamide or an N-bromo-N-alkyl sulphonamide in which the alkyl group is a $C_1$-$C_4$ alkyl group.

**17.** The method according to one of the preceding claims, wherein the composition Z1 is an aqueous solution or dispersion with a pH in a range from 4 to 12.

**18.** The method according to claim 17, wherein the composition Z1 is an aqueous solution or dispersion with a pH in a range from 6 to 8.

**19.** The method according to one of the preceding claims, wherein the composition Z1 comprises the organic compound in a concentration in a range from 0.1 to 50 wt.%, relative to the total weight of the composition Z1.

**20.** The method according to claim 19, wherein the composition Z1 comprises the organic compound in a concentration in a range from 1 to 20 wt.%, relative to the total weight of the composition Z1.

**21.** The method according to one of the preceding claims, wherein the composition Z1 used in process step ii) comprises as further component cyanuric acid as stabiliser, in addition to the organic compound defined in claim 1.

**22.** The method according to one of the preceding claims, wherein the bringing into contact of the electrically conductive layer with the composition Z1 in process step ii) takes place by dipping the electrically conductive layer into the composition Z1 or by printing the electrically conductive layer with the composition Z1.

**23.** The method according to one of the preceding claims, wherein the method comprises as a further process step:

iii) Washing the electrically conductive layer brought into contact with the composition Z1.

**24.** The method according to one of the preceding claims, wherein the electrically conductive layer remains in contact with the composition Z1 for 1 second to 30 minutes.

**Patentansprüche**

**1.** Ein Verfahren zum Strukturieren einer Schichtstruktur, umfassend die Verfahrensschritte:

i) Bereitstellen einer Schichtstruktur umfassend ein Substrat und eine elektrisch leitfähige Schicht, die auf das Substrat aufgebracht ist, welche ein elektrisch leitfähiges Polymer umfasst;
ii) für die Zwecke der Strukturierung, Inkontaktbringen von mindestens einem Teil der Oberfläche der elektrisch leitfähigen Schicht mit einer Zusammensetzung Z1, die eine organische Verbindung umfasst, die in der Lage ist, Chlor, Brom oder Iod freizusetzen, wobei die organische Verbindung mindestens ein Strukturelement (I) umfasst

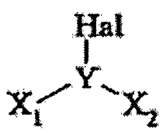

(I)

wobei

- Hal ein aus der Gruppe bestehend aus Chlor, Brom oder Iod ausgewähltes Halogen ist,
- Y aus N, S und P gewählt ist, und
- $X_1$ und $X_2$ gleich oder verschieden sein können, und jeweils für ein Halogen, ein Kohlenstoffatom oder ein Schwefelatom stehen, und wobei ein oder mehrere weitere Atome optional an $X_1$ und $X_2$ gebunden sein können.

**2.** Das Verfahren nach Anspruch 1, wobei die Zusammensetzung Z1 eine wässrige Lösung oder Dispersion mit einem pH-Wert von mindestens 4 ist.

**3.** Das Verfahren nach Anspruch 1 oder 2, wobei die elektrisch leitfähige Schicht zusätzlich zu dem elektrisch leitfähigen Polymer ein Polyanion umfasst.

**4.** Das Verfahren nach Anspruch 3, wobei die elektrisch leitfähige Schicht Komplexe bestehend aus Poly-(3, 4-ethylendioxythiophen) und Polystyrol-Sulfonsäure umfasst.

**5.** Das Verfahren nach einem der vorangehenden Ansprüche, wobei die elektrisch leitfähige Schicht durch ein Verfahren erhalten werden kann, das folgende Verfahrensschritte umfasst:

ia) Bereitstellung des Substrats;
ib) Aufbringen einer Zusammensetzung Z2 umfassend das elektrisch leitfähige Polymer und ein Lösungsmittel auf mindestens einen Teil der Oberfläche des Substrats;
ic) Zumindest teilweises Entfernen des Lösungsmittels, um eine elektrisch leitfähige Schicht zu erhalten.

**6.** Das Verfahren nach Anspruch 5, wobei die Zusammensetzung Z2 eine Dispersion umfassend Komplexe aus Poly-(3, 4-ethylendioxythiophen) und Polystyrol-Sulfonsäure ist.

**7.** Das Verfahren nach einem der Ansprüche 1 bis 6, wobei die organische Verbindung mindestens zwei Strukturelemente (I) umfasst, wobei Hal für ein Chloratom oder ein Bromatom steht und Y für Stickstoff steht, wobei die mindestens zwei Strukturelemente (I) optional voneinander verschieden sein können.

**8.** Das Verfahren nach Anspruch 7, wobei die organische Verbindung das Strukturelement (II) umfasst

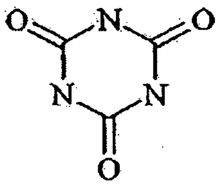

(II)

wobei ein Chloratom oder ein Bromatom an mindestens zwei der Stickstoffatome gebunden ist.

**9.** Das Verfahren nach Anspruch 8, wobei die organische Verbindung Natriumdichlor-diisocyanurat, Natriumdibromdiisocyanurat, Tribromisocyanursäure oder Trichlorisocyanursäure ist.

**10.** Das Verfahren nach einem der Ansprüche 1 bis 9, wobei die organische Verbindung das Strukturelement (III) umfasst

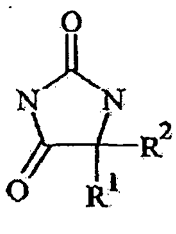

(III)

wobei ein Chloratom oder ein Bromatom an die zwei Stickstoffatome gebunden ist, und wobei $R^1$ und $R^2$ gleich oder verschieden sein können und für ein Wasserstoffatom oder eine $C_1$-$C_4$-Alkylgruppe stehen.

**11.** Das Verfahren nach Anspruch 10, wobei die organische Verbindung 1-Brom-3-chlor-5,5-dimethylhydantoin, 1-Chlor-3-brom-5,5-dimethylhydantoin, 1,3-Dichlor-5,5-dimethylhydantoin oder 1,3-Dibrom-5,5-dimethylhydantoin ist.

**12.** Das Verfahren nach einem der Ansprüche 1 bis 6, wobei die organische Verbindung nur ein Strukturelement (I) umfasst, wobei Y für N steht.

**13.** Das Verfahren nach Anspruch 12, wobei die organische Verbindung N-Chlorsuccinimid oder N-Bromsuccinimid ist.

**14.** Das Verfahren nach Anspruch 12, wobei die organische Verbindung das Strukturelement (IV) umfasst

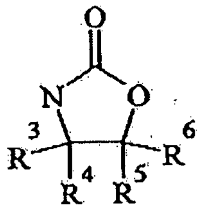

(IV)

wobei ein Chloratom oder ein Bromatom an das Stickstoffatom gebunden ist, und wobei $R^3$ $R^4$, $R^5$ und $R^6$ gleich oder verschieden sein können und für ein Wasserstoffatom oder eine $C_1$-$C_4$-Alkylgruppe stehen, die optional mit Brom oder Chlor substituiert sein kann.

**15.** Das Verfahren nach Anspruch 14, wobei die organische Verbindung aus der Gruppe bestehend aus 3-Brom-5-chlormethyl-2-oxazolidinon, 3-Chlor-5-chlormethyl-2-oxazolidinon, 3-Brom-5-brommethyl-2-oxazolidinon und 3-Chlor-5-brommethyl-2-oxazolidinon ausgewählt ist.

**16.** Das Verfahren nach Anspruch 12, wobei die organische Verbindung Halazon, ein N,N-Di-chlorsulphonamid, ein N-Chlor-N-alkylsulphonamid oder ein N-Brom-N-alkylsulphonamid ist, bei dem die Alkylgruppe eine $C_1$-$C_4$-Alkylgruppe ist.

**17.** Das Verfahren nach einem der vorangehenden Ansprüche, wobei die Zusammensetzung Z1 eine wässrige Lösung oder Dispersion mit einem pH-Wert im Bereich von 4 bis 12 ist.

**18.** Das Verfahren nach Anspruch 17, wobei die Zusammensetzung Z1 eine wässrige Lösung oder Dispersion mit einem pH-Wert im Bereich von 6 bis 8 ist.

**19.** Das Verfahren nach einem der vorangehenden Ansprüche, wobei die Zusammensetzung Z1 die organische Verbindung in einer Konzentration im Bereich von 0,1 bis 50 Gewichts-% im Verhältnis zum Gesamtgewicht der Zusammensetzung Z 1 umfasst.

**20.** Das Verfahren nach Anspruch 19, wobei die Zusammensetzung Z1 die organische Verbindung in einer Konzentration im Bereich von 1 bis 20 Gewichts-% im Verhältnis zum Gesamtgewicht der Zusammensetzung Z1 umfasst.

**21.** Das Verfahren nach einem der vorangehenden Ansprüche, wobei die in Verfahrensschritt ii) verwendete Zusammensetzung Z1 als weiteren Bestandteil zusätzlich zu der in Anspruch 1 definierten organischen Verbindung Cyanursäure als Stabilisator umfasst.

**22.** Das Verfahren nach einem der vorangehenden Ansprüche, wobei das Inkontaktbringen der elektrisch leitfähigen Schicht mit der Zusammensetzung Z1 in Verfahrensschritt ii) durch Tauchen der elektrisch leitfähigen Schicht in die Zusammensetzung Z1 oder durch Bedrucken der elektrisch leitfähigen Schicht mit der Zusammensetzung Z1 stattfindet.

**23.** Das Verfahren nach einem der vorangehenden Ansprüche, wobei das Verfahren als weiteren Verfahrensschritt Folgendes umfasst:

iii) Waschen der elektrisch leitfähigen Schicht, die mit der Zusammensetzung Z1 in Kontakt gebracht wurde.

**24.** Das Verfahren nach einem der vorangehenden Ansprüche, wobei die elektrisch leitfähige Schicht für 1 Sekunde bis 30 Minuten mit der Zusammensetzung Z1 in Kontakt bleibt.

## Revendications

**1.** Méthode de structuration d'une structure stratifiée, comprenant les étapes de procédé suivantes :

i) Fourniture d'une structure stratifiée comprenant un substrat et une couche électriquement conductrice, appliquée sur le substrat, qui comprend un polymère électriquement conducteur ;
ii) Pour la structuration, l'amenée d'au moins une partie de la surface de la couche électriquement conductrice au contact d'une composition Z1 comprenant un composé organique capable de libérer du chlore, du brome ou de l'iode, le composé organique comprenant au moins un élément structural (I)

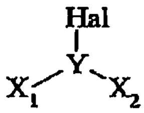

(I)

dans lequel

- Hal est un atome d'halogène choisi dans le groupe constitué par un atome de chlore, de brome ou d'iode,
- Y est choisi parmi N, S et P, et
- $X_1$ et $X_2$ peuvent être identiques ou différents et chacun représente respectivement un atome d'halogène, un atome de carbone ou un atome de soufre, et dans lequel un ou plusieurs autres atomes peuvent éventuellement être liés à $X_1$ et à $X_2$.

**2.** Méthode selon la revendication 1, dans laquelle la composition Z1 est une solution aqueuse ou une dispersion ayant un pH d'au moins 4.

**3.** Méthode selon la revendication 1 ou 2, dans laquelle la couche électriquement conductrice comprend un polyanion en plus du polymère électriquement conducteur.

**4.** Méthode selon la revendication 3, dans laquelle la couche électriquement conductrice comprend des complexes constitués de poly(3,4-éthylènedioxythiophène) et d'acide polystyrène sulfonique.

**5.** Méthode selon l'une des revendications précédentes, dans laquelle la couche électriquement conductrice peut être obtenue par une méthode comprenant les étapes de procédés suivantes :

ia) La fourniture du substrat ;
ib) L'application d'une composition Z2 comprenant le polymère électriquement conducteur et un solvant sur au moins une partie de la surface du substrat ;
ic) L'élimination au moins partielle du solvant pour obtenir une couche électriquement conductrice.

**6.** Méthode selon la revendication 5, dans laquelle la composition Z2 est une dispersion comprenant des complexes constitués de poly(3,4-éthylènedioxy-thiophène) et d'acide polystyrène sulfonique.

**7.** Méthode selon l'une des revendications 1 à 6, dans laquelle le composé organique comprend au moins deux éléments structuraux (I) dans lesquels Hal représente un atome de chlore ou un atome de brome et Y représente un atome d'azote, lesdits au moins deux éléments structuraux (I) pouvant éventuellement être différents l'un de l'autre.

**8.** Méthode selon la revendication 7, dans laquelle le composé organique comprend l'élément structural (II)

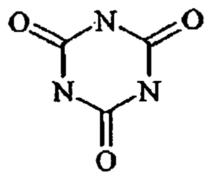

(II)

dans lequel un atome de chlore ou un atome de brome est lié à au moins deux des atomes d'azote.

**9.** Méthode selon la revendication 8, dans laquelle le composé organique est un dichlorodiisocyanurate de sodium, un dibromodiisocyanurate de sodium, un acide tribromoisocyanurique ou un acide trichloroisocyanurique.

**10.** Méthode selon l'une des revendications 1 à 9, dans laquelle le composé organique comprend l'élément structural (III)

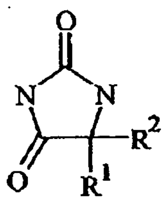

(III)

dans lequel un atome de chlore ou un atome de brome est lié aux deux atomes d'azote et dans lequel $R^1$ et $R^2$ peuvent être identiques ou différents et représentent un atome d'hydrogène ou un groupe alkyle $C_1$-$C_4$.

**11.** Méthode selon la revendication 10, dans laquelle le composé organique est une 1-bromo-3-chloro-5,5-diméthylhydantoïne, 1-chloro-3-bromo-5,5-diméthyl-hydantoïne, 1,3-dichloro-5,5-diméthylhydantoïne ou 1,3-dibromo-5,5-diméthyl-hydantoïne.

**12.** Méthode selon l'une des revendications 1 à 6, dans laquelle le composé organique comprend juste un seul élément structural (I), dans lequel Y représente N.

**13.** Méthode selon la revendication 12, dans laquelle le composé organique est un N-chlorosuccinimide ou N-bromosuccinimide.

**14.** Méthode selon la revendication 12, dans laquelle le composé organique comprend l'élément structural (IV)

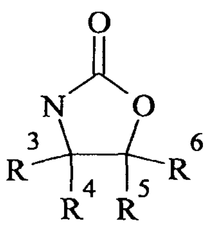

(IV)

dans lequel un atome de chlore ou un atome de brome est lié à l'atome d'azote et dans lequel $R^3$, $R^4$, $R^5$ et $R^6$ peuvent être identiques ou différents et représentent un atome d'hydrogène ou un groupe alkyle $C_1$-$C_4$, qui peut éventuellement être substitué par un atome de brome ou de chlore.

**15.** Méthode selon la revendication 14, dans laquelle le composé organique est choisi dans le groupe constitué par la 3-bromo-5-chlorométhyl-2-oxazolidinone, 3-chloro-5,-chlorométhyl-2-oxazolidinone, 3-bromo-5-bromométhyl-2-oxazolidinone et 3-chloro-5-bromométhyl-2-oxazolidinone.

**16.** Méthode selon la revendication 12, dans laquelle le composé organique est une halazone, un N,N-dichlorosulfonamide, un N-chloro-N-alkyl-sulfonamide ou un N-bromo-N-alkylsulfonamide dans lequel le groupe alkyle est un groupe alkyle $C_1$-$C_4$.

**17.** Méthode selon l'une des revendications précédentes, dans laquelle la composition Z1 est une solution aqueuse ou une dispersion ayant un pH dans une plage de 4 à 12.

**18.** Méthode selon la revendication 17, dans laquelle la composition Z1 est une solution aqueuse ou une dispersion ayant un pH dans la plage de 6 à 8.

**19.** Méthode selon l'une des revendications précédentes, dans laquelle la composition Z1 comprend le composé organique à une concentration dans une plage de 0,1 à 50 % en poids, par rapport au poids total de la composition Z1.

**20.** Méthode selon la revendication 19, dans laquelle la composition Z1 comprend le composé organique à une concentration dans une plage de 1 à 20 % en poids, par rapport au poids total de la composition Z1.

**21.** Méthode selon l'une des revendications précédentes, dans laquelle la composition Z1 utilisée dans l'étape de procédé ii) comprend à titre de composant supplémentaire un stabilisant de type acide cyanurique, en plus du composé organique défini dans la revendication 1.

**22.** Méthode selon l'une des revendications précédentes, dans laquelle l'amenée de la couche électriquement conductrice au contact de la composition Z1 dans l'étape de procédé ii) est mise en oeuvre par immersion de la couche électriquement conductrice dans la composition Z1 ou par impression de la couche électriquement conductrice avec la composition Z1.

**23.** Méthode selon l'une des revendications précédentes, dans laquelle la méthode comprend à titre d'étape de procédé supplémentaire :

iii) Le lavage de la couche électriquement conductrice amenée au contact de la composition Z1.

**24.** Méthode selon l'une des revendications précédentes, dans laquelle la couche électriquement conductrice reste au contact de la composition Z1 pendant 1 seconde à 30 minutes.

Fig. 1

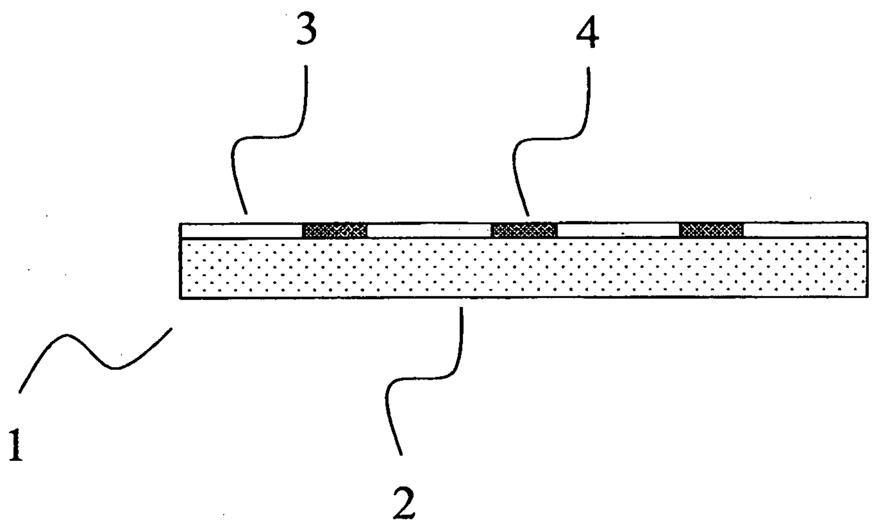

Fig. 2

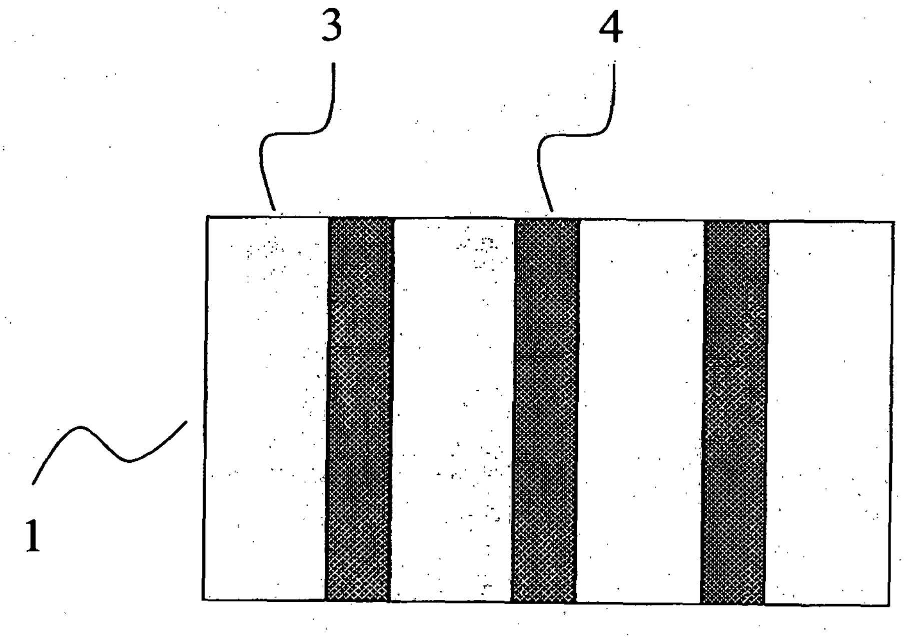

Fig. 3

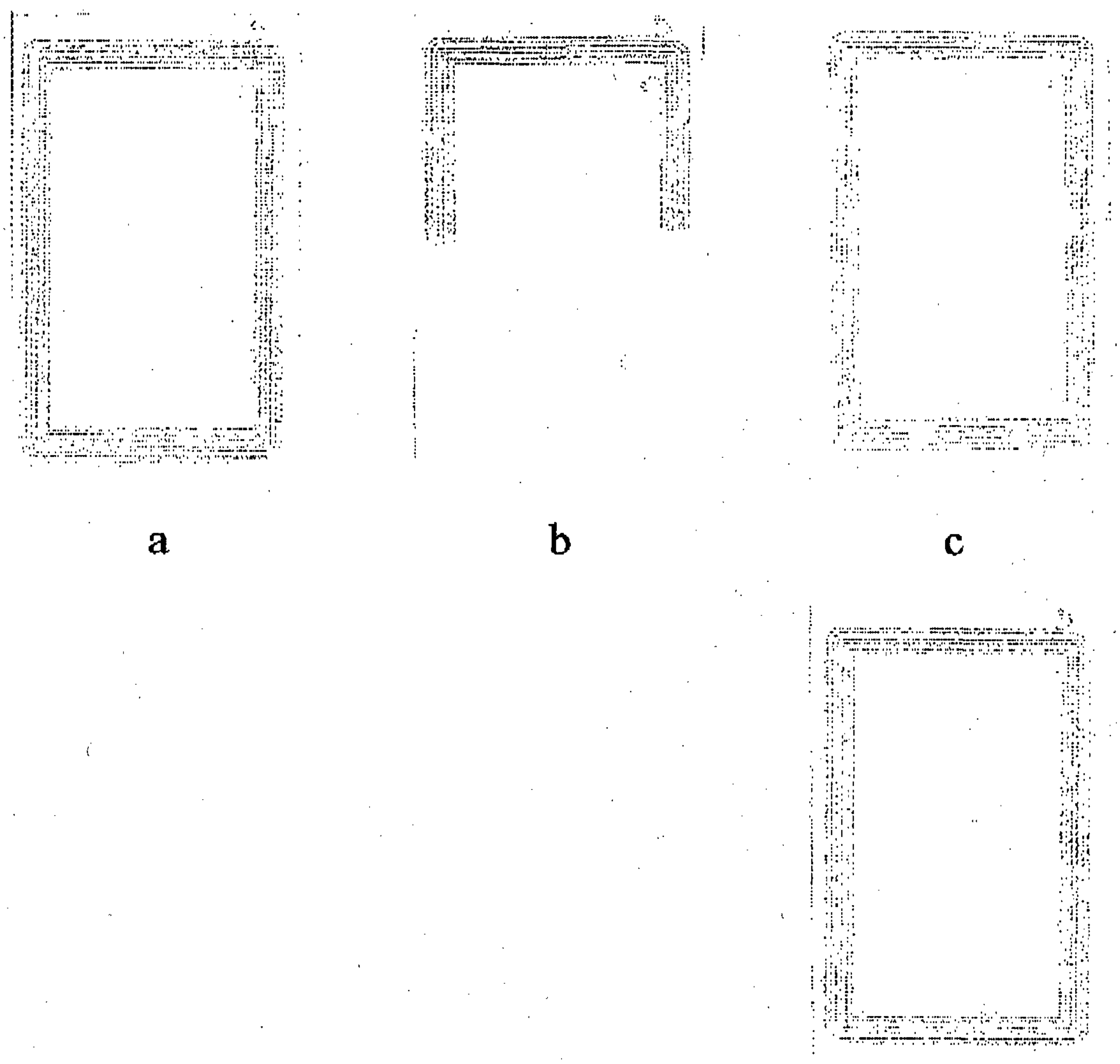

a b c

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 0339340 A2
- EP 0440957 A2
- EP 1227529 A2
- EP 1054414 A
- WO 2009122923 A
- WO 2008041461 A
- WO 0139287 A1
- US 2008187764 A1
- JP 2004047446 A
- EP 2704205 A2
- US 6943571 B1


### Non-patent literature cited in the description


- **L. GROENENDAAL ; F. JONAS ; D. FREITAG ; H. PIELARTZIK ; J. R. REYNOLDS.** *Adv. Mater.,* 2000, vol. 12, 481-494
- **V. KABANOV.** *Russian Chemical Reviews,* 2005, vol. 74, 3-20
- **HOUBEN WEYL.** Methoden der organischen Chemie. *Makromolekulare Stoffe,* 1987, vol. E 20, 1141 ff
- *J. Am. Chem. Soc.,* 1963, vol. 85, 454
- *J. Polym. Sc. Part A Polymer Chemistry,* 1988, vol. 26, 1287